# EUROPÄISCHE PATENTSCHRIFT

(11) **EP 1 116 422 B1**
(45) Veröffentlichungstag und Bekanntmachung des Hinweises auf die Patenterteilung: **01.12.2004**
(21) Anmeldenummer: 00938534.5
(22) Anmeldetag: 10.05.2000
(51) Int. Cl.: H05K 5/00

(54) **ELEKTRISCHES GERÄT**
ELECTRICAL DEVICE
APPAREIL ELECTRIQUE

(30) Priorität: 12.05.1999 DE 19921928
(43) Veröffentlichungstag der Anmeldung: 18.07.2001
(73) Patentinhaber: ROBERT BOSCH GMBH, 70442 Stuttgart (DE)
(72) Erfinder: HAUPT, Martin, Cowbridge CF7 17BR (GB); MAYER, Frank, D-71640 Ludwigsburg (DE); SCHWEINBENZ, Jochen, D-70469 Stuttgart (DE); SCHIEFER, Peter, D-74199 Untergruppenbach (DE); SCHINZEL, Ralf, D-71672 Marbach am Neckar (DE)
(86) Internationale Anmeldenummer: PCT/DE2000/001463
(87) Internationale Veröffentlichungsnummer: WO 2000/070922

(56) Entgegenhaltungen:
- DE-U- 9 318 985

## Beschreibung

### Stand der Technik

Die Erfindung betrifft ein elektrisches Gerät, insbesondere ein elektronisches Steuer- oder Regelgerät für eine elektromechanische Anordnung, nach dem Oberbegriff des Hauptanspruchs.

Es ist bereits aus der DE-OS 39 37 190 ein elektrisches Gerät bekannt, bei dem die Steuergeräteelektronik für Komponenten eines Verbrennungsmotor in einem Gehäuse angeordnet ist, das im Bereich der Motoraggregate angebracht ist. Das zweiteilige Gehäuse aus Metall lässt sich elektromagnetisch abgeschirmt verschließen, wobei in das Gehäuse eine Anschlussvorrichtung für Verbindungsleitungen integriert ist über die die Spannungsversorgung und die Übertragung von Mess- und Steuersignalen möglich ist.

Aus der DE 196 25 757.3 A1 ist es auch bekannt, die Anschlussvorrichtung mit Steckkontakten in einer Kunststoffsteckerleiste zu realisieren, wobei die Kunststoffsteckerleiste ein Spritzgussteil ist und beim Spritzgießen in weitere Gehäuseteile integriert ist.

Bei der Herstellung solcher Gehäuse für ein elektrisches Gerät, insbesondere zur Steuerung elektromechanischer Anordnungen beispielsweise im Kraftfahrzeug, muss beachtet werden, dass sowohl eine dichte Verbindung der Gehäuseteile als auch eine gute elektromagnetische Abschirmung (EMV) für die Steuergeräteelektronik bei möglichst geringem Herstellungsaufwand erreichbar ist.

### Vorteile der Erfindung

Das eingangs beschriebene elektrische Gerät mit einem aus mindestens zwei Gehäuseteilen bestehenden Gehäuse und einer im Gehäuse anordbaren elektronischen Schaltung und mit einer am Gehäuse befestigbaren Anschlussvorrichtung für die Spannungsversorgung des Geräts und/oder die Signalübertragung zu der elektronischen Schaltung ist erfindungsgeinäß mit den kennzeichnenden Merkmalen des Anspruchs 1 weitergebildet. Das Gerät ist insbesondere dadurch vorteilhaft, dass die Gehäuseteile an einer Fügekante mittels Laserschweißen dicht aneinanderfügbar sind, wodurch sich eine gute mechanische und dynamische Festigkeit des Gehäuses ergibt. Das Gerät ist darüber hinaus weitgehend manipulationsgeschützt, da es nicht ohne Beschädigung demontierbar ist.

Mit der Erfindung kann in vorteilhafter Weise ein neues Montage- und Abdichtkonzepte, beispielsweise für elektronische Steuergeräte, realisiert werden, mit dem die Lösung der Dichtproblematik zwischen den Fügepartnern aus verschiedenen Werkstoffen, mit dem Ziel eine stoffschlüssige, dichte Verbindung herzustellen, möglich ist. Somit kann eine Steigerung der Leistungsfähigkeit des Steuergerätes durch die Erhöhung der mechanischen und dynamischen Festigkeit und durch ein verbessertes EMV-Verhalten im geschlossenen Gehäuseverbund erreicht werden.

Das thermische Verhalten des erfindungsgemäßen Geräts kann ebenfalls durch den gleichmäßigen Klemmverband an thermisch kritischen Stellen verbessert werden, da eine Verschraubung entfällt und damit die großflächige Wärmeabfuhr gewährleistet ist.

Das für sich gesehen bekannte Laserstrahlschweißen eignet sich für verschiedene Werkstoffkombinationen wie Aluminiumguß und Aluminiumblech, wobei hier eine hohe Energie an der Schweißstelle erzeugt werden kann bei einer relativ geringen Wärmeentwicklung am zu verschweißenden Werkstück. Das Laserschweißen kombiniert die zwei sonst getrennt ablaufenden Arbeitsgänge, wie eine Dichtung auftragen und die anschließende Montage der Gehäuseteile durch Verschrauben, zu einem Arbeitsgang. Dies führt neben der Vereinfachung der Montage zu einer Reduzierung der Teilevielfalt durch die Einsparung von Schrauben, Einpresshülsen und Dichtungen.

Es ist hiermit auch erreichbar, dass eine die elektronische Schaltung tragende Leiterplatte zwischen den Gehäuseteilen derart zu liegen kommt, dass sie durch das Verschweißen fest eingespannt ist. Auf der Leiterplatte werden damit auch in vorteilhafter Weise Tabuzonen reduziert, die sonst für eine Verschraubung oder Vernietung notwendig wären.

Gemäß der Erfindung wird die Anschlussvorrichtung mit einem Schweißflansch versehen, der derart zwischen den Gehäuseteilen zu liegen kommt, dass eine zumindest kraftschlüssige Verbindung der Gehäuseteile unter Einspannung der Anschlussvorrichtung herstellbar ist. Hierbei ist auf einfache Weise auch eine vollständig stoffschlüssige Verbindung an der Fügekante unter Einschluss der Anschlussvorrichtung herstellbar, wobei keine komplexe Dicht- und Schraubgeometrie an der Fügekante notwendig ist. Die Gehäuseteile und der Schweißflansch sind aus Metall, vorzugsweise aus Aluminium, hergestellt. Die Anschlussvorrichtung weist aufgrund ihrer komplexen Formgebung ein Kunststoffpritzgussteil auf, das die Steckkontakte oder die Verbindungsleitungen für die elektrischen Verbindungen nach außen trägt und den Schweißflansch durch umgossene Bereiche hält.

In vorteilhafter Weise ist der Schweißflansch so ausgebildet, dass er die Anschlussvorrichtung vollständig umschließt und außen von den Gehäuseteilen eingefasst wird, so dass er leicht mit den Gehäuseteilen ebenfalls mittels Laserschweißen verbindbar ist.

Mit der Erfindung können somit auf einfache Weise die beiden abzudichtenden Teile wie Anschlussvorrichtung und Gehäuse des elektrischen Geräts ohne Verwendung eines Dichtstoffes stoff- und kraftschlüssig verbunden werden. Dies ist insbesondere beim Vorhandensein von aggressiven Medien in der Umgebung des Gehäuses wichtig, da die Medienbeständigkeit solcher Dichtstoffe kritisch ist. Um die Verbindung zwischen den an sich nicht verschweißbaren Werkstoffpartnern Kunststoff (Anschlussvorrichtung) und Aluminiumblech (Gehäuseteile) herzustellen, wird der erfindungsgemäße Schweißflansch vorgesehen.

Die Ausbildung der Fügekante kann dadurch verbessert werden, dass die Fügekante aus sich überlappenden Bereichen der Gehäuseteile gebildet ist und als Schweißnaht eine zwischen den überlappenden Bereichen verlaufende Überlappnaht gebildet ist. Weiterhin kann in vorteilhafter Weise als Schweißnaht eine an der äußeren Stoßkante der überlappenden Bereiche und der Stoßkante des Schweißflansches an den anliegenden Gehäusebereichen verlaufende Bördelnaht gebildet werden, die eine dichte Verbindungsstelle gewährleistet.

Gemäß einer Ausführungsform ist an mindestens einem der Gehäuseteile ein Befestigungswinkel mittels des gleichen Laserschweißverfahrens anbringbar, wodurch nach der Gehäusemontage eine Anbringung flexibler, anwendungsorientierter Adaptionselemente möglich ist.

Das erfindungsgemäße elektrische Gerät kann beispielsweise eine Steuer- und/oder Regelanordnung für eine elektromechanisches Bauteil in einem Kraftfahrzeug sein, da hier die Dichtheit des Gehäuses und die dynamische Festigkeit außerordentlich wichtig ist.

Diese und weitere Merkmale von bevorzugten Weiterbildungen der Erfindung gehen außer aus den Ansprüchen, einschließlich der rückbezogenen Unteransprüche, auch aus der Beschreibung und den Zeichnungen hervor, wobei die einzelnen Merkmale jeweils für sich allein oder zu mehreren in Form von Unterkombinationen bei der Ausführungsform der Erfindung und auf anderen Gebieten verwirklicht sein und vorteilhafte sowie für sich schutzfähige Ausführungen darstellen können, für die hier Schutz beansprucht wird.

### Zeichnung

Ein Ausführungsbeispiel eines elektrischen Geräts mit einem laserverschweißten Gehäuse wird anhand der Zeichnung erläutert. Es zeigen:
Figur 1 eine schematische Ansicht eines Gehäuses mit einer elektrischen Anschlussvorrichtung und einem Befestigungswinkel;
Figur 2 einen Schnitt A-A durch den Bereich der Fügekante an sich überlappenden, nach unten gebogenen Gehäusebereichen und dem Befestigungswinkel und
Figur 3 einen Schnitt B-B durch den Bereich des Gehäuses mit der Anschlussvorrichtung, die eine Kunststoffspritzgusskörper enthält.

### Beschreibung des Ausführungsbeispiels

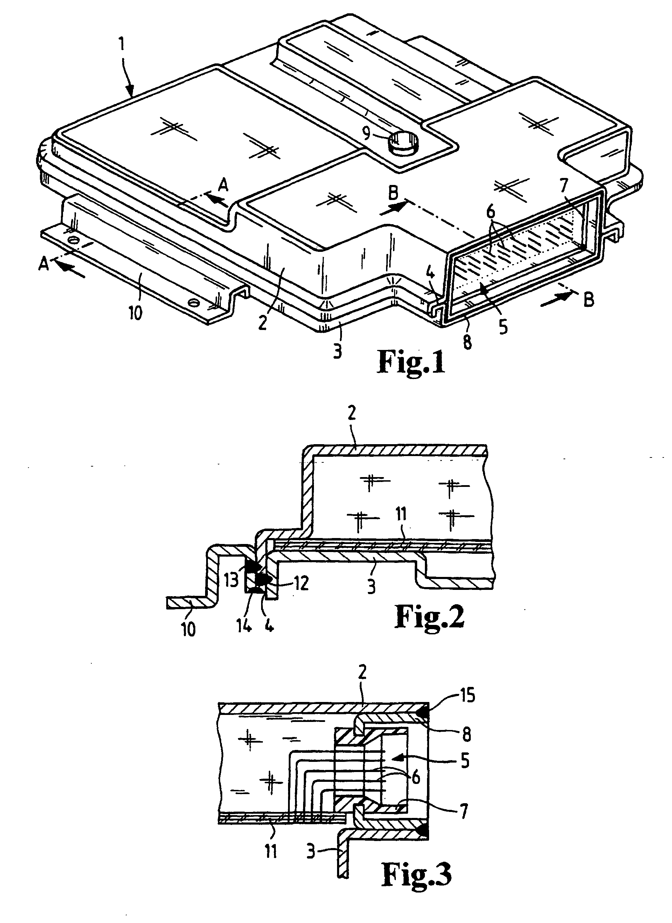

In Figur 1 ist ein elektrisches Gerät mit einem Gehäuse 1 gezeigt, das ein oberes Gehäuseteil 2 und ein unteres Gehäuseteil 3 aufweist. Die Gehäuseteile 2 und 3 aus Aluminiumblech liegen an einer Fügekante 4 aneinander und sind hier laserverschweißt. Die Fügekante 4 ist aus überlappenden Bereichen des Aluminiumbleches gebildet, die nach unten gebogen sind, wobei hier jedoch auch andere, dem jeweiligen Anwendungsfall angepasste Konstruktionen möglich sind.

Am elektrischen Gerät ist weiterhin eine Anschlussvorrichtung 5 mit Steckkontakten 6 für die Spannungsversorgung oder zur Kontaktierung von Signalleitungen vorhanden. Die Steckkontakte 6 sind hier in einem Kunststoffspritzgusskörper 7 der Anschlussvorrichtung 5 umspritzt und der Kunststoffspritzgusskörper 7 ist von einem Schweißflansch 8, ebenfalls aus Aluminiumblech, eingefasst. Der Schweißflansch 8 ist außen ebenfalls an den Gehäuseteilen 2 und 3 laserverschweißt, wie es weiter unten noch erläutert wird.

Beim Ausführungsbeispiels nach der Figur 1 ist noch ein Druckausgleichselement 9 angeordnet, wie es insbesondere für ein vollständig dichtes Gehäuse 1 notwendig ist. Außen am unteren Gehäuseteil 3 ist beim dargestellten Ausführungsbeispiel noch ein Befestigungswinkel 10 ebenfalls durch Laserverschweißung angebracht.

Aus einer Schnittdarstellung nach Figur 2 ist erkennbar, wie eine Leiterplatte 11 zwischen dem oberen Gehäuseteil 2 und dem unteren Gehäuseteil 3 beim Laserverschweißen fest eingespannt werden kann. Ferner ist aus der Figur 2 ersichtlich, wie eine Schweißnaht als Überlappnaht 12 zwischen den Gehäuseteilen 2 und 3 sowie als Überlappnaht 13 zwischen dem oberen Gehäuseteil 2 und dem Befestigungswinkel 10 angebracht ist, wobei eine Schweißnaht 14 als Bördelnaht jeweils umlaufend an der gesamten Fügekante 4 und dem jeweiligen Anlagebereich des Befestigungswinkels 10 angeordnet ist.

In einer weiteren detaillierten Schnittdarstellung nach Figur 3 ist der Kunststoffspritzgusskörper 7 der Anschlussvorrichtung 5 erkennbar, in den durch Umspritzung der Schweißflansch 8 eingefügt ist. Der Schweißflansch 8 ist durch Laserverschweißen an einer Bördelnaht 15 fest und dicht mit dem oberen Gehäuseteil 2 und dem unteren Gehäuseteil 3 verbunden.

## Patentansprüche

1. Elektrisches Gerät, mit
- einem aus mindestens zwei Gehäuseteilen (2,3) bestehenden Gehäuse (1) und einer im Gehäuse (1) anordbaren elektronischen Schaltung und mit
- einer am Gehäuse (1) befestigbaren Anschlussvorrichtung (5) für die Spannungsversorgung des Geräts und/oder die Signalübertragung zu der elektronischen Schaltung, **dadurch gekennzeichnet, dass**
- die Gehäuseteile (2,3) an einer Fügekante (4) mittels Laserschweißen aneinander gefügt sind und dass
- die Anschlussvorrichtung (5) mit einem Schweißflansch (8) versehen ist, der derart zwischen den Gehäuseteilen (2,3) zu liegen kommt, dass eine zumindest kraftschlüssige Verbindung der Gehäuseteile (2,3) unter Einschluss der Anschlussvorrichtung (5) herstellbar ist.

2. Elektrisches Gerät nach Anspruch 1, **dadurch gekennzeichnet, dass**
- eine vollständig stoffschlüssige Verbindung an der Fügekante (4) unter Einschluss der Anschlussvorrichtung (5) herstellbar ist.

3. Elektrisches Gerät nach Anspruch 1 oder 2, **dadurch gekennzeichnet, dass**
- die Gehäuseteile (2,3) und der Schweißflansch (8) aus Metall, vorzugsweise aus Aluminium, sind und die Anschlussvorrichtung (8) ein Kunststoffpritzgussteil (7) enthält, dass Steckkontakte (6) oder Verbindungsleitungen und den Schweißflansch (8) zumindest teilweise umschließt.

4. Elektrisches Gerät nach einem der vorhergehenden Ansprüche, **dadurch gekennzeichnet, dass**
- der Schweißflansch (8) die Anschlussvorrichtung (5) vollständig umschließt und außen von den Gehäuseteilen (2,3) eingefasst und mit ihnen verschweißt wird.

5. Elektrisches Gerät nach einem der vorhergehenden Ansprüche, **dadurch gekennzeichnet, dass**
- die Fügekante (4) aus sich überlappenden Bereichen der. Gehäuseteile (2,3) gebildet ist.

6. Elektrisches Gerät nach Anspruch 5, **dadurch gekennzeichnet, dass**
- als Schweißnaht eine zwischen den überlappenden Bereichen verlaufende Überlappnaht (12;13) gebildet ist.

7. Elektrisches Gerät nach Anspruch 5 oder 6, **dadurch gekennzeichnet, dass**
- als Schweißnaht eine an der äußeren Stoßkante der überlappenden Bereiche und der Stoßkante des Schweißflansches an den anliegenden Gehäusebereichen (2,3) verlaufenden Bördelnaht (14,15)gebildet ist.

8. Elektrisches Gerät nach einem der vorhergehenden Ansprüche, **dadurch gekennzeichnet, dass**
- an mindestens einem der Gehäuseteile (3) ein Befestigungswinkel (10) mittels des gleichen Laserschweißverfahrens anbringbar ist.

9. Elektrisches Gerät nach einem der vorhergehenden Ansprüche, **dadurch gekennzeichnet, dass**
- eine die elektronische Schaltung tragende Leiterplatte (11) zwischen den Gehäuseteilen (2,3) derart zu liegen kommt, dass sie durch das Verschweißen fest eingespannt ist.

10. Elektrisches Gerät nach einem der vorhergehenden Ansprüche, **dadurch gekennzeichnet, dass**
- das elektrische Gerät ein Steuer- und/oder Regelanordnung für ein elektromechanisches Bauteil in einem Kraftfahrzeug ist.

## Claims

1. Electrical device, with
- a housing (1), comprising at least two housing parts (2, 3) and an electronic circuit which can be arranged in the housing (1) and with
- a connecting device (5), which can be fastened to the housing (1), for supplying a voltage to the device and/or signal transmission to the electronic circuit, **characterized in that**
- the housing parts (2, 3) are joined to each other by means of laser welding at a joining edge (4) and **in that**
- the connecting device (5) is provided with a welding flange (8), which comes to lie between the housing parts (2, 3) in such a way that an at least nonpositive connection of the housing parts (2, 3) can be established, while enclosing the connecting device (5).

2. Electrical device according to Claim 1, **characterized in that**
- a completely materially bonded connection can be established at the joining edge (4), while enclosing the connecting device (5).

3. Electrical device according to Claim 1 or 2, **characterized in that**
- the housing parts (2, 3) and the welding flange (8) are made of metal, preferably of aluminium, and the connecting device (8) includes a plastic injection-moulded part (7), which at least partly encloses the plug contacts (6) or connecting lines and the welding flange (8).

4. Electrical device according to one of the preceding claims, **characterized in that**
- the welding flange (8) completely encloses the connecting device (5) and is encompassed by the housing parts (2, 3) and welded to them.

5. Electrical device according to one of the preceding claims, **characterized in that**
- the joining edge (4) is formed by overlapping regions of the housing parts (2, 3).

6. Electrical device according to Claim 5, **characterized in that**
- a lap seam (12; 13) running between the overlapping regions is formed as the weld seam.

7. Electrical device according to Claim 5 or 6, **characterized in that**
- a flange seam (14, 15) running along the outer abutting edge of the overlapping regions and the abutting edge of the welding flange at the adjoining housing regions (2, 3) is formed as the weld seam.

8. Electrical device according to one of the preceding claims, **characterized in that**
- a fastening angle (10) can be attached to at least one of the housing parts (3) by means of the same laser welding process.

9. Electrical device according to one of the preceding claims, **characterized in that**
- a printed circuit board (11) carrying the electronic circuit comes to lie between the housing parts (2, 3) in such a way that it is securely fixed in place by the welding.

10. Electrical device according to one of the preceding claims, **characterized in that**
- the electrical device is a controlling and/or regulating arrangement for an electromechanical component in a motor vehicle.

## Revendications

1. Appareil électrique comprenant
- un boîtier (1) composé d'au moins deux pièces de boîtier (2, 3) et d'un circuit électronique pouvant être disposé dans le boîtier (1) et
- un moyen de connexion (5) pouvant être fixé sur le boîtier (1) pour l'alimentation en tension de l'appareil et/ou la transmission de signaux vers le circuit électronique,
**caractérisé en ce que**
- les pièces de boîtier (2, 3) sont adaptées les unes aux autres par soudure au laser sur une arête de jointure (4), et
- le moyen de connexion (5) est doté d'une bride à souder (8) qui vient se placer entre les pièces de boîtier (2, 3) de manière à ce qu'une liaison des pièces de boîtier (2, 3) au moins par complémentarité de force puisse être créée en incluant le moyen de connexion (5).

2. Appareil électrique selon la revendication 1,
**caractérisé en ce qu'**
une liaison complète par la matière est réalisée sur l'arête de jointure (4) en incluant le moyen de connexion (5).

3. Appareil électrique selon la revendication 1 ou 2,
**caractérisé en ce que**
les pièces de boîtier (2, 3) et la bride à souder (8) sont en métal, de préférence en aluminium, et le moyen de connexion (5) comprend une pièce injectée en matière plastique (7) entourant au moins partiellement les contacts à fiche (6) ou les lignes de liaison et la bride à souder (8).

4. Appareil électrique selon l'une quelconque des revendications précédentes,
**caractérisé en ce que**
la bride à souder (8) entoure complètement le moyen de connexion (5) et elle est bordée à l'extérieur par les pièces de boîtier (2,3) auxquelles elle est soudée.

5. Appareil électrique selon l'une quelconque des revendications précédentes,
**caractérisé en ce que**
l'arête de jointure (4) est formée à partir de zones se chevauchant des pièces de boîtier (2, 3).

6. Appareil électrique selon la revendication 5,
**caractérisé en ce qu'**
une soudure à recouvrement (12, 13) en forme de cordon de soudure s'étend entre les zones se chevauchant.

7. Appareil électrique selon la revendication 5 ou 6,
**caractérisé en ce qu'**
un joint à bord bridé (14, 15) formé comme cordon de soudure s'étend sur le rebord extérieur des zones se chevauchant et sur le rebord de la bride à souder sur les zones de boîtier (2, 3) adjacentes.

8. Appareil électrique selon l'une quelconque des revendications précédentes, **caractérisé en ce qu'**
une cornière de fixation (10) est reliée à au moins une des pièces de boîtier (3) à l'aide du même procédé de soudure au laser.

9. Appareil électrique selon l'une quelconque des revendications précédentes,
**caractérisé en ce qu'**
une carte de circuit imprimé (11) supportant le circuit électronique vient se placer entre les pièces de boîtier (2, 3) de manière à être encastrée fixement par soudage.

10. Appareil électrique selon l'une quelconque des revendications précédentes,
**caractérisé en ce que**
l'appareil électrique est un dispositif de commande et/ou de régulation pour un composant électromécanique d'un véhicule automobile.
